# EUROPEAN PATENT APPLICATION

(11) **EP 4 488 697 A1**
(43) Date of publication of application: **08.01.2025**
(21) Application number: 23183914.3
(22) Date of filing: 06.07.2023
(51) Int. Cl.: G01R 31/327

(54) **METHOD AND SYSTEM FOR INDICATING WEAR OF A SWITCHABLE COMPONENT OF A TEST AND MEASUREMENT EQUIPMENT**

(71) Applicant: Rohde & Schwarz GmbH & Co. KG, 81671 München (DE)
(72) Inventor: Ruengeler, Matthias, 81671 München (DE)
(74) Representative: Prinz & Partner mbB

(57) **Abstract**

The invention relates to a method of indicating wear of a switchable component (12) of a test and measurement equipment (14). The method comprises the steps of:
- Obtaining information about a switching of the switchable component (12),
- Processing the information by means of a processing circuit (18), thereby determining a switching cycle rate,
- Comparing the switching cycle rate determined with a threshold value, and
- Outputting at least one alert by means of at least one indicator (32) in case the threshold value is reached or exceeded.

Further, a system (10) for indicating wear of a switchable component (12) of a test and measurement equipment (14).

## Description

The invention relates to a method of indicating wear of a switchable component of a test and measurement equipment. Further, the invention relates to a system for indicating wear of a switchable component of a test and measurement equipment.

In the state of the art, a test and measurement equipment is known that typically comprises a switchable component like a relay that is switched during operation of the test and measurement equipment. For instance, the test and measurement equipment may be an oscilloscope, a signal generator, a signal analyzer, a spectrum analyzer, a network analyzer or similar devices used for tests and measurements of a device under test. However, a relay only supports a limited amount of operation cycles, namely switching cycles. Since the relay is very expensive, unnecessary switching of the relay should be avoided in order to reduce the wear of the relay.

An operator who sits in front of the test and measurement equipment directly hears the relay clicking when a script makes the relay switching, for instance a new remote control script executed for the first time. In case the switching of the relay takes place all the time, which should be avoided, the operator is notified directly due to the sound generated by the relay.

In case the test and measurement equipment is operated via a remote device, for instance a computer via a LAN connection. Hence, the operator will not know that the script executed will wear out the relay in a few minutes.

Consequently, remote operation of a test and measurement equipment is not possible when testing a new script, as it is necessary that the operator sits next to the test and measurement equipment when executing the new script for the first time in order to directly obtain a feedback from the test and measurement equipment.

Accordingly, there is a need to make remote operation of a test and measurement equipment possible, particularly when executing a new script, while simultaneously minimizing the risk of fast wear of expensive components of the test and measurement equipment, e.g. wear of a relay.

The invention provides a method of indicating wear of a switchable component of a test and measurement equipment, for instance a relay. The method comprises the steps of:
- Obtaining information about a switching of the switchable component,
- Processing the information by means of a processing circuit, thereby determining a switching cycle rate,
- Comparing the switching cycle rate determined with a threshold value, and
- Outputting at least one alert by means of at least one indicator in case the threshold value is reached or exceeded.

Further, the invention provides a system for indicating wear of a switchable component of a test and measurement equipment, for instance a relay. The system comprises a processing circuit, a comparison circuit, a control circuit and at least one indicator. The processing circuit is configured to obtain and process information about a switching of the switchable component, thereby determining a switching cycle rate. The comparison circuit is configured to compare the switching cycle rate determined with a threshold value. The control circuit is configured to control the at least one indicator to output at least one alert in case the threshold value is reached or exceeded.

The main idea of the invention is to make the clicking of the switchable component of the test and measurement equipment, for instance the relay, indicative to an operator even though the operator does not sit next to the test and measurement equipment. This is achieved by obtaining the information concerning the switching of the at least one switchable component, wherein the respective information is processed so as to obtain the information if the switching of the switchable component is critical or not, namely by means of the switching cycle rate. In other words, the absolute number of switching is not taken into account, but the frequency, e.g. the number within a defined time span.

Accordingly, the invention enables the operator to execute a new script on the test and measurement equipment even though the operator is not directly interacting with the test and measurement equipment while simultaneously ensuring that the switchable component is not subjected to too high wear due to a high switching cycle rate.

In general, the respective circuits, namely the processing circuit, the comparison circuit and/or the control circuit, may relate to sub-circuits of one common circuit. In other words, a single circuitry may comprise the respective circuits.

Alternatively, the respective circuits, namely the processing circuit, the comparison circuit and/or the control circuit, may be established by separate circuitries. Then, these circuits may be provided in different devices and/or at different locations. The respective circuits may communicate with each other in order to forward information and/or data to be processed further accordingly.

In general, the test and measurement equipment may be an oscilloscope, a signal generator, a signal analyzer, a spectrum analyzer, a network analyzer or similar devices used for tests and measurements of a device under test.

An aspect provides that the alert is an acoustic alert that is output by means of an acoustic indicator. Hence, the at least one indicator may be an acoustic indicator. The alert may be output by a sound in order to inform the operator acoustically. The acoustic alert may be a beep or a melody. Moreover, the alert may relate to a tone that is output in a repetitive manner.

Alternatively or additionally, the alert is a visual alert that is output by means of an optical indicator. The at least one indicator may be an optical indicator. Thus, the visual alert may be displayed on a display or a screen, for instance in a certain color and/or by means of a certain text message, e.g. "Alert". The text message may be in bold and/or capital letters. For instance, a signal color, e.g. red, may be used to alert the operator. In other words, an area in the signal color may be displayed wherein the respective text message is visualized within the area.

Generally, the alert may be generated locally and/or remotely, namely remotely with respect to the location of the test and measurement equipment. Furthermore, the alert may be output locally and/or remotely, namely remotely with respect to the location of the test and measurement equipment. This can be ensured due to the fact that the information is obtained and processed by means of the processing circuit whereas the control circuit controls the indicator to output the alert, which may be separately formed with respect to the processing circuit.

In fact, the processing circuit may also be located remotely with respect to the test and measurement equipment while receiving the information about the switching of the switchable component via a communication interface.

Particularly, the acoustic alert, for instance a signal, can be made hearable locally at the test and measurement equipment. Alternatively or additionally, the acoustic alert, namely the signal, may be made hearable by means of a remote device, for instance via a soundcard of a separately formed device, namely a remotely located indicator. For instance, a headphone or similar is used.

Consequently, the alert may be output remotely, e.g. the visual alert and/or the acoustic alert, even though the switchable component is located elsewhere, for instance at a measurement site. Particularly, the switchable component is integrated in the test and measurement equipment. Hence, an operator interacting with the test and measurement equipment having the switchable component via a remote computer, e.g. a desktop computer, receives the alert, namely the visual alert on the screen and/or the acoustic alert via a loudspeaker.

The information about the switching of the switchable component may be obtained by analyzing a script executed on the test and measurement equipment or by analyzing a script to be executed on the test and measurement equipment. Accordingly, the processing circuit may be configured to obtain the information about the switching of the switchable component by analyzing a script executed on the test and measurement equipment or by analyzing a script to be executed on the test and measurement equipment. Therefore, the information may be obtained during the execution of the new script on the test and measurement equipment, namely live or rather during real operation of the test and measurement equipment but in a theoretical manner while analyzing the script during its execution. Alternatively, the information may be gathered previously based on the information encompassed in the script that shall be executed on the test and measurement equipment. Prior to executing the script, an analysis of the script may take place in order to obtain the information about the switching of the switchable component and to alert the operator as soon as possible in case that the threshold value may be reached or rather exceeded.

Alternatively, the information about the switching of the switchable component is obtained by measuring a switching operation of the switchable component. For instance, a sound of the switchable component is recorded during its operation. In other words, the system may comprise a sensor that is configured to measure a switching operation of the switchable component, particularly to record a sound of the switchable component, such that the information about the switching is obtained. The sensor is connected to the processing circuit such that the information about the switching is forwarded to the processing circuit. The processing circuit may further process the information in order to determine the switching cycle rate. Hence, the information may also be gathered by sensing a parameter, for instance a current or a voltage. The sensor may also record a sound generated by the switchable component in order to obtain the information about the switching of the switchable component. Hence, the sensor may be configured to measure switching cycles of the switchable component.

According to a further aspect, the threshold value and/or the alert is adaptable. For instance, the system may comprise at least one user interface via which an operator is enabled to adapt the threshold value and/or to adapt the alert. The threshold value may be adapted based on information obtained about the test and measurement equipment, particularly the switchable component. The threshold value may decrease with the operating hours of the switchable component, which may be recorded, such that an alert is output earlier in case of an older or rather longer used switchable component. Hence, a previous replacement of the switchable component may result in a higher threshold value. Generally, the operator is enabled to adapt the settings according to his personal preferences.

In a similar manner, the operator is enabled to customize the alert. For instance, the operator may set whether the alert shall be an optical alert or rather an acoustic alert. Of course, the operator may also set the at least one alert to be both, namely an optical alert and an acoustic alert simultaneously.

Further, the operator may configure whether the at least one alert shall be output (only) locally and/or remotely.

Moreover, the operator may configure that a sound, for instance a clicking sound, is output every time the switchable component switches, namely the relay. The respective clicking sound may be output remotely, thereby simulating the acoustic environment of the test and measurement equipment at the premises of the operator that may control the test and measurement equipment from remote.

Generally, the respective configuration may be done locally and/or remotely. Hence, the operator may configure the alert or rather the clicking sound via a remote computer (remotely) or at the test and measurement equipment (locally).

In case of an optical alert, the operator may also set the way how the optical alert is output, for instance the color, the content of a text message and/or size of the text message. In case of an acoustic alert, the operator may configure the loudness, the tone, the frequency and/or a melody.

A further aspect provides that a first alert is output in case a first threshold value is reached or exceeded, wherein a second alert is output in case a second threshold value is reached or exceeded. The first alert is different to the second alert and/or the first threshold value is different to the second threshold value. For instance, a cascade of alerts may be set in order to escalate an alarming, particularly in dependence of the switching cycle rate determined.

For instance, the first alert associated with the first threshold value may be activated when the switching cycle rate determined is higher than expected, but still within an acceptable range. Once the switching cycle rate determined increases, the second threshold value may be reached or exceeded, thereby causing the second alert to be output that is different to the first alert, for instance louder or colored differently. Alternatively or additionally, the first alert may be associated with only an optical alert, whereas the second alert is a combination of an optical alert and an acoustic alert. The first alert may also be a locally output alert, whereas the second alert is a locally and remotely output alert.

Generally, different alert scenarios may be customized by the operator and stored such that the control circuit selects the corresponding alert based on the switching cycle rate determined.

Furthermore, the alert may be output remotely, particularly based on a push notification. The push notification may be output in addition to the alert output via the indicator. Alternatively, the alert is only output by means of a push notification such that the device receiving and processing the push notification is the indicator. Hence, the push notification may be the only alert that is output. Thus, the at least one indicator may be a remotely located device, for instance a mobile that receives the push notification accordingly.

The system may comprise a communication interface that is configured to forward a signal indicative of the alert to be output remotely, particularly to forward the signal indicative of the alert by a push notification. Hence, the alert may be forwarded to a different device, e.g. at an authority, which communicates with the system via the respective communication interface, for instance an Ethernet interface.

A management entity or a service provider may receive the control signal of the control circuit or rather the signal indicative of the alert. The respective signal may be processed in order to output the alert, thereby informing staff of the management entity or rather the service provider.

The alert may be output remotely with respect to the test and measurement equipment having the switchable component, in particular receives the alert via a remote computer while interacting with the test and measurement equipment via the remote computer. Again, the operator may control the test and measurement equipment via a remote computer while receiving the alert at the remote computer used for remotely controlling the test and measurement equipment. The alert may be displayed on the screen or output as a sound via a soundcard or a loudspeaker connected with the remote computer.

The alert output may be acknowledged by an operator. For instance, the operator may interact with the user interface in order to acknowledge the alert output. The acknowledgment may relate to a manual override or rather a switching-off of the alert. Thus, further execution of the script or rather operation of the test and measurement equipment can be ensured, particularly without any disturbance. Furthermore, it can be avoided by acknowledging the alert in due time that the staff of the management entity or rather the service provider gets alerted.

Generally, the system, for instance the processing circuit, may be configured to record each individual switching cycle of the switchable component and to calculate the respective switching cycle rate based on the records.

Further aspects and advantages of the claimed subject matter will become more readily appreciated as the same become better understood by reference to the following detailed description, when taken in conjunction with the accompanying drawings. In the drawings,
- Figure 1 schematically shows an overview of a system according to the invention, and
- Figure 2 schematically shows an illustrative example of an optical alert output.

The detailed description set forth below in connection with the appended drawings, where like numerals reference like elements, is intended as a description of various embodiments of the disclosed subject matter and is not intended to represent the only embodiments. Each embodiment described in this disclosure is provided merely as an example or illustration and should not be construed as preferred or advantageous over other embodiments. The illustrative examples provided herein are not intended to be exhaustive or to limit the claimed subject matter to the precise forms disclosed.

For the purposes of the present disclosure, the phrase "at least one of A, B, and C", for example, means (A), (B), (C), (A and B), (A and C), (B and C), or (A, B, and C), including all further possible permutations when more than three elements are listed. In other words, the term "at least one of A and B" generally means "A and/or B", namely "A" alone, "B" alone or "A and B".

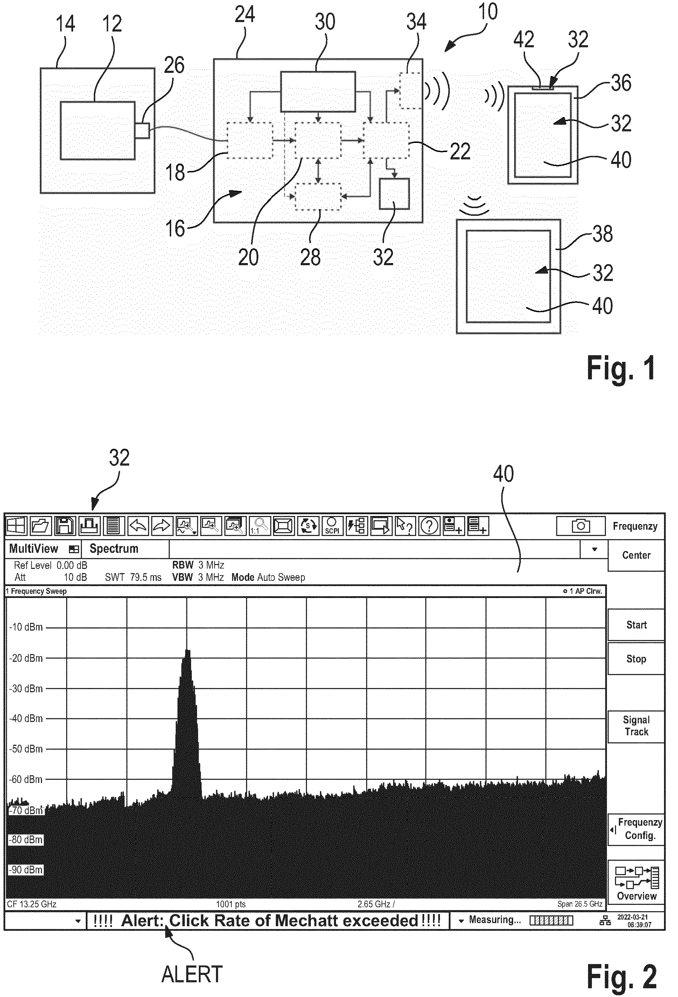

In Figure 1, a system 10 is shown that is used for indicating wear of a switchable component 12 of a test and measurement equipment 14, for instance an oscilloscope, a signal generator, a signal analyzer, a spectrum analyzer, a network analyzer or similar devices used for tests and measurements of a device under test. The switchable component 12 may be a relay.

The system 10 comprises a single circuitry 16 that has several sub-circuits, namely a processing circuit 18, a comparison circuit 20 and a control circuit 22. The respective circuits 18 to 22 are located within a single device 24 having a housing that encompasses the single circuitry 16, namely the processing circuit 18, the comparison circuit 20 and the control circuit 22.

In addition, the system 10 comprises a sensor 26 that is configured to measure a switching operation of the switchable component 12. The sensor 26 is connected to the processing circuit 18 such that the data/information gathered by the sensor 26 is forwarded to the processing circuit 18. This ensures that the processing circuit 18 obtains information about the switching of the switchable component 12.

Furthermore, the system 10, particularly the device 24, comprises a storage medium 28 that may inter alia store a threshold value used for comparison purposes. Accordingly, the storage medium 28 can be accessed by the comparison circuit 20 as will be described later in more detail.

The device 24 also has a user interface 30 via which an operator of the system 10 can interact with the circuitry 16 in order to make settings.

In general, the system 10, particularly the sensor 26, is enabled to measure a switching operation of the switchable component 12 of the test and measurement equipment 14 once a script is executed by means of the test and measurement equipment 14.

The sensor 26 may sense a current, a voltage or record a sound generated by the switchable component 12 during operation in order to obtain information about the switching of the switchable component 12.

The information obtained is forwarded to and processed by means of the processing circuit 18 in order to determine a switching cycle rate of the switchable component 12 during operation of the test and measurement equipment 14, e.g. when executing the script.

The switching cycle rate determined by means of the processing circuit 18 is forwarded to the comparison circuit 20 that accesses the storage medium 28 while comparing the switching cycle rate determined with the threshold value stored.

In case the switching cycle rate determined reaches or exceeds the threshold value, the comparison circuit 20 outputs a respective signal to be processed by the control circuit 22.

The control circuit 22 controls at least one indicator 32 to output an alert.

The at least one indicator 32 may be arranged locally, e.g. at the device 24. Alternatively, a separately formed indicator 32 may be provided that receives the control signal from the control circuit 22 or rather a signal indicative of the alert to be output.

Accordingly, the system 10, particularly the device 24, comprises a communication interface 34 via which the signal indicative of the alert to be output remotely can be forwarded to a separately formed device, for instance a mobile phone 36, a desktop computer 38 or similar.

The respective signal output via the communication interface 34 may relate to a push notification such that the alert can be pushed to the separately formed device, e.g. the mobile phone 36 and/or the desktop computer 38, via the communication interface 34.

In any case, the at least one indicator 32 may be an optical indicator 40, for instance a display or a screen, and/or an acoustic indicator 42, for instance a loudspeaker, a headphone or similar.

Therefore, the alert may relate to an acoustic alert and/or an optical alert.

In general, the at least one indicator 32 may be a local one that is located next to the test and measurement equipment 14, e.g. integrated within the device 24 located next to the test and measurement equipment 14.

Alternatively, the at least one indicator 32 is a remote one, for instance a screen of the desktop computer 38 that is operated remotely with respect to the test and measurement equipment 14, e.g. via a LAN connection. The desktop computer 38 may also be used to control or rather execute the script on the remotely located test and measurement equipment 14.

On the same desktop computer 38, the alert may be output in order to warn the operator directly.

The optical alert ("ALERT") may be output by means of a text message displayed on the screen together with a certain color in order to highlight the warning as shown in Figure 2.

Generally, the system 10 may use different alert scenarios, for instance two or more steps/alerts that are associated with different threshold values.

Hence, an alert escalation may take place in order to alert the operator according to the risk of wear of the switchable component 12 which depends on the switching cycle rate determined.

In fact, a first alert may be output in case a first threshold value is reached or exceeded, wherein a second alert is output in case a second threshold value is reached or exceeded. The alerts are different from each other with regard to their type of alert, e.g. optical or rather acoustic.

Moreover, the threshold values may be different such that a different warning may be output depending on the switching cycle rate determined.

For instance, a cascade of alerts may be provided in order to escalate the alarming, particularly in dependence of the switching cycle rate determined

The control circuit 22 may access the storage medium 28 in order to obtain information with regard to the alert scenario to be applied.

In general, the operator may adapt the threshold value and/or the alert, for instance the kind or rather type of the alert, by means of the user interface 30 according to the preferences of the operator.

The operator of the system 10 may also acknowledge the alert via the user interface 30 such that operation of the system 10 is not interrupted, for instance by an authority that is informed by means of the push notification, preferably as part of a second alert, e.g. a second step of an alert scenario.

Alternatively to the sensing, the system 10 may be configured to obtain the information about the switching of the switchable component 12 by analyzing a script that is actually executed on the test and measurement equipment 14 or rather by analyzing a script to be executed on the test and measurement equipment 14, namely prior to its execution.

Accordingly, a theoretical analysis of the script to be executed can take place in order to determine, particularly prior to its execution, whether the script will cause the switchable component 12 to be operated with a switching cycle rate that reaches or exceeds the at least one threshold value.

Alternatively to the shown embodiment of Figure 1, the respective circuits 18-22, namely the processing circuit 18, the comparison circuit 20 and/or the control circuit 22, may be established by separate circuitries. These circuits 18-22 may be provided in different devices and/or at different locations. The respective circuits 18-22 may communicate with each other in order to forward information and/or data to be processed further accordingly.

Certain embodiments disclosed herein, particularly the respective module(s) and/or unit(s), utilize circuitry (e.g., one or more circuits) in order to implement standards, protocols, methodologies or technologies disclosed herein, operably couple two or more components, generate information, process information, analyze information, generate signals, encode/decode signals, convert signals, transmit and/or receive signals, control other devices, etc. Circuitry of any type can be used.

In an embodiment, circuitry includes, among other things, one or more computing devices such as a processor (e.g., a microprocessor), a central processing unit (CPU), a digital signal processor (DSP), an application-specific integrated circuit (ASIC), a field-programmable gate array (FPGA), a system on a chip (SoC), or the like, or any combinations thereof, and can include discrete digital or analog circuit elements or electronics, or combinations thereof. In an embodiment, circuitry includes hardware circuit implementations (e.g., implementations in analog circuitry, implementations in digital circuitry, and the like, and combinations thereof).

In an embodiment, circuitry includes combinations of circuits and computer program products having software or firmware instructions stored on one or more computer readable memories that work together to cause a device to perform one or more protocols, methodologies or technologies described herein. In an embodiment, circuitry includes circuits, such as, for example, microprocessors or portions of microprocessor, that require software, firmware, and the like for operation. In an embodiment, circuitry includes one or more processors or portions thereof and accompanying software, firmware, hardware, and the like.

The present application may reference quantities and numbers. Unless specifically stated, such quantities and numbers are not to be considered restrictive, but exemplary of the possible quantities or numbers associated with the present application. Also in this regard, the present application may use the term "plurality" to reference a quantity or number. In this regard, the term "plurality" is meant to be any number that is more than one, for example, two, three, four, five, etc. The terms "about", "approximately", "near" etc., mean plus or minus 5% of the stated value.

## Claims

1. A method of indicating wear of a switchable component (12) of a test and measurement equipment (14), wherein the method comprises the steps of:
- Obtaining information about a switching of the switchable component (12),
- Processing the information by means of a processing circuit (18), thereby determining a switching cycle rate,
- Comparing the switching cycle rate determined with a threshold value, and
- Outputting at least one alert by means of at least one indicator (32) in case the threshold value is reached or exceeded.

2. The method of claim 1, wherein the alert is an acoustic alert that is output by means of an acoustic indicator (42) and/or wherein the alert is a visual alert that is output by means of an optical indicator (40).

3. The method according to any one of the preceding claims, wherein the information about the switching of the switchable component (12) is obtained by analyzing a script executed on the test and measurement equipment (14) or by analyzing a script to be executed on the test and measurement equipment (14).

4. The method according to claim 1 or 2, wherein the information about the switching of the switchable component (12) is obtained by measuring a switching operation of the switchable component (12), particularly by recording a sound of the switchable component (12).

5. The method according to any one of the preceding claims, wherein the threshold value and/or the alert is adaptable.

6. The method according to any one of the preceding claims, wherein a first alert is output in case a first threshold value is reached or exceeded, wherein a second alert is output in case a second threshold value is reached or exceeded, and wherein the first alert is different to the second alert and/or wherein the first threshold value is different to the second threshold value.

7. The method according to any one of the preceding claims, wherein the alert is output remotely, particularly based on a push notification.

8. The method according to claim 7, wherein the alert is output remotely with respect to the test and measurement equipment (14) having the switchable component (12), in particular wherein an operator receives the alert via a remote computer while interacting with the test and measurement equipment (14) via the remote computer.

9. The method according to any one of the preceding claims, wherein the alert output is acknowledged by an operator.

10. A system (10) for indicating wear of a switchable component (12) of a test and measurement equipment (14), wherein the system (10) comprises a processing circuit (18), a comparison circuit (20), a control circuit (22) and at least one indicator (32), wherein the processing circuit (18) is configured to obtain and process information about a switching of the switchable component (12), thereby determining a switching cycle rate, wherein the comparison circuit (20) is configured to compare the switching cycle rate determined with a threshold value, and wherein the control circuit (22) is configured to control the at least one indicator (32) to output at least one alert in case the threshold value is reached or exceeded.

11. The system (10) according to claim 10, wherein the at least one indicator (32) is an optical indicator (40) or an acoustic indicator (42).

12. The system (10) according to claim 10 or 11, wherein the processing circuit (18) is configured to obtain the information about the switching of the switchable component (12) by analyzing a script executed on the test and measurement equipment (14) or by analyzing a script to be executed on the test and measurement equipment (14).

13. The system (10) according to claim 10 or 11, wherein the system (10) comprises a sensor (26) that is configured to measure a switching operation of the switchable component (12), particularly to record a sound of the switchable component (12), such that the information about the switching is obtained, and wherein the sensor (26) is connected to the processing circuit (18) such that the information about the switching is forwarded to the processing circuit (18).

14. The system (10) according to any one of the claims 10 to 13, wherein the system (10) comprises at least one user interface (30) via which an operator is enabled to acknowledge the alert output, to adapt the threshold value and/or to adapt the alert.

15. The system (10) according to any one of the claims 10 to 14, wherein the system (10) comprises a communication interface (34) that is configured to forward a signal indicative of the alert to be output remotely, particularly to forward the signal indicative of the alert by a push notification.
